# DEMANDE DE BREVET EUROPEEN

(11) **EP 0 905 495 A1**
(43) Date de publication de la demande: **31.03.1999**
(21) Numéro de dépôt: 97116893.5
(22) Date de dépôt: 29.09.1997
(51) Int. Cl.: G01L 9/00, H01L 21/308

(54) **Couche de protection de circuits intégrés, et son procédé de fabrication**

(71) Demandeur: EM Microelectronic-Marin SA, 2074 Marin (CH)
(72) Inventeur: Münch, Ulrich, 2000 Neuchâtel (CH); Schneeberger, Niklaus, 8600 Dübendorf (CH); Jaeggi, Dominik, 1700 Fribourg (CH)
(74) Mandataire: Balsters, Robert

(57) **Abrégé**

La présente invention concerne une structure (21) formée sur un substrat (23) constitué d'un matériau de base destiné à être gravé par un agent réactif, cette structure comprenant au moins une première couche externe (29), ou couche de passivation, qui a un premier comportement élastique. Cette structure comprend en outre au moins une seconde couche externe (33) formée au-dessus de la première couche, de sorte que la seconde couche a un second comportement élastique qui est différent du premier comportement élastique. Dans le cas où le second comportement élastique confère, à la seconde couche, une élasticité en compression qui est supérieure à celle de la première couche, ladite structure a avantageusement un rendement supérieur à 99,8 %.

## Description

La présente invention concerne le domaine des circuits intégrés et, plus particulièrement, des couches de protection de circuits intégrés, et leurs procédés de fabrication.

Dans le cadre de certaines applications spécifiques, on réalise communément un micro-usinage d'un substrat formé en silicium, notamment par un procédé de gravure humide.

Dans le cas où ce substrat comprend des circuits intégrés, une telle gravure ne peut être réalisée qu'après avoir fabriqué les circuits, c'est-à-dire après la formation d'une couche de passivation. En effet, certains composés de la solution de gravure tels que les alcalins (par exemple l'ion K⁺) peuvent contaminer la filière de fabrication, et provoquer des dégradations de circuits intégrés.

Le brevet US 5,387,316 décrit un capteur de pression. La figure 1 de la présente description représente un tel capteur 1 comprenant une membrane 3 qui est formée en réalisant une cavité 5 dans un substrat semiconducteur 7. Le substrat 7 est formé en silicium, et la cavité 5 est aménagée en le gravant dans une solution composée d'un agent de gravure tel que KOH. En outre, puisque le nitrure de silicium ne peut être gravé par l'agent KOH, une couche 9 est formée en nitrure de silicium pour servir de masque lors de la gravure du substrat 7 par KOH.

Dans le cas où le substrat 7 comprend des circuits intégrés, le capteur comprend alors des zones susceptibles d'être attaquées par l'agent réactif de la solution de gravure du substrat 7. Par exemple, le substrat 7 peut comprendre des plots de connexion formés en aluminium, pouvant être attaqués par l'agent KOH. Il en résulte qu'il est nécessaire de protéger de telles zones. On utilise alors classiquement un équipement mécanique, comme cela est décrit dans la thèse de D. Jaeggi, "Thermal Converters by CMOS technology", ETH Zurich N° 11567, pp. 58 et 59.

Un inconvénient du micro-usinage d'un substrat de ce type réside dans le fait qu'il nécessite la mise en oeuvre d'un équipement mécanique spécifique à la gravure KOH.

Un autre inconvénient d'utiliser un tel équipement réside dans le fait qu'il ne permet qu'un traitement plaquette par plaquette, ce qui va à l'encontre des préoccupations habituelles de coût et de rendement dans l'industrie des semiconducteurs.

Comme cela a déjà été mentionné ci-dessus, une couche de passivation est formée sur le substrat et les circuits intégrés associés, pour leur conférer une protection contre des agressions chimiques telles que l'humidité ou des contaminants, ou contre des agressions mécaniques telles que des contraintes ou des poussières.

Dans le domaine des capteurs de pression tels que décrits dans le brevet US 5,387,316 déjà cité, on réalise communément de fines membranes sujettes à des déformations, de sorte qu'elles subissent des forces internes qui les rendent non planes. De ce fait, on forme alors, sur une telle membrane, une couche de passivation généralement en nitrure de silicium, de manière à la rendre plane. En effet, une couche en nitrure de silicium provoque une contrainte notable susceptible d'agir sur le substrat, notamment sur ses bords. On dépose donc une couche en nitrure de silicium comprenant une faible contrainte. Autrement dit, cette couche doit avoir un comportement élastique qui lui confère une élasticité en traction.

A ce titre, on rappelle qu'une traction (ou une compression) simple correspond, selon la physique des matériaux, à une unique contrainte mécanique dirigée selon une direction déterminée. Typiquement, dans le cas d'une poutre ayant un axe de révolution donné, une telle contrainte est exercée selon la direction de cet axe. Autrement dit, d'un point mathématique, le tenseur des contraintes ne comporte qu'un seul terme et, dans la base d'espace formée des directions principales de contrainte, sa représentation matricielle est diagonale.

Dans le cas d'un substrat en silicium pourvu d'une couche de passivation du type susmentionné, une gravure par KOH de ce substrat peut occasionner diverses dégradations.

En effet, quand on réalise une telle couche de passivation, il est ensuite nécessaire de réaliser des zones d'ouverture au travers de cette couche, de manière à pouvoir former un contact électrique avec des circuits intégrés inférieurs, notamment via des plots de connexion. Typiquement, on utilise l'aluminium pour réaliser ces plots. L'homme de l'art note que l'agent KOH peut également attaquer l'aluminium de plots de connexion découverts, ce qui peut occasionner une détérioration des circuits intégrés auxquels sont connectés ces plots.

Par ailleurs, puisque la gravure par KOH est de type anisotrope, les faces latérales des lignes séparant deux puces successives peuvent être également le siège d'une attaque par l'agent KOH, ce qui peut occasionner une dégradation de ces puces.

En outre, la couche de passivation peut comprendre des trous dans lesquels la solution de gravure peut être canalisée. Il en résulte que l'agent KOH peut attaquer des couches inférieures, et occasionner une possible dégradation de circuits intégrés.

Bon nombre de solutions ont été apportées pour pallier les inconvénients susmentionnés. Toutefois, elles n'ont pas apporter jusqu'à présent une pleine satisfaction, eu égard aux préoccupations habituelles dans l'industrie des semiconducteurs, liées au coût, au rendement et à l'environnement.

A titre d'exemple, les brevets US 4,155,866 et US 4,113,551 décrivent respectivement l'utilisation de EDP (acronyme de l'anglais "Ethylène Diamine Pyrocatechol") et de TMAH (acronyme de l'anglais "TetraMethylAmmonium Hydroxide") pour remplacer l'agent de gravure KOH. Un avantage d'utiliser l'agent EDP ou TMAH réside dans le fait que ces composants gravent le silicium, mais n'attaquent pas l'aluminium.

Toutefois, ces agents présentent des inconvénients non négligeables, au regard des préoccupations susmentionnées.

En effet, par rapport à l'agent KOH, les agents EDP et TMAH sont plus onéreux et moins stables. En effet, la Demanderesse de la présente invention a observé que la stabilité de l'agent KOH est de l'ordre de quelques mois, et celles des agents TMAH et EDP de l'ordre de quelques heures et quelques minutes, respectivement. La Demanderesse de la présente invention a également observé que, dans le cas où la couche en aluminium est formée sur une couche en TiW utilisée en tant que barrière de diffusion entre l'aluminium et le silicium, l'agent TAMH peut attaquer la couche en TiW. En outre, l'agent EDP est supposé pouvoir être cancérigène.

A titre d'exemple également, un article intitulé "Fluorocarbon film for protection from alkaline etchant" de Y. Matsumoto, issu d'une conférence à Chicago intitulée TRANSDUCERS '97, décrit l'utilisation d'une couche de protection supplémentaire formée en fluorocarbone sur la couche de passivation.

Un inconvénient d'utiliser un composant tel que le fluorocarbone réside dans le fait que celui-ci nécessite des équipements supplémentaires pour le mettre en oeuvre dans un environnement industriel où il n'est pas communément utilisé.

Un autre inconvénient d'utiliser un tel composant réside dans le fait qu'il n'est pas compatible avec les étapes de photolithographie classiques, puisque ce composant nécessite l'utilisation d'une résine spécifique. En outre, on a observé que cette résine est susceptible de se décoller facilement, de sorte qu'elle ne peut être utilisée comme masque en photolithographie.

Un objet de la présente invention est de prévoir une couche de protection de circuits intégrés sur substrat, cette couche étant résistante à l'agent réactif KOH, et palliant les inconvénients susmentionnés.

Un autre objet de la présente invention est de prévoir une telle couche répondant aux critères traditionnels en industrie liés au coût, au rendement et à l'environnement, eu égard aux matériaux utilisés pour former cette couche.

Un autre objet de la présente invention est de prévoir un procédé propre à fabriquer une telle couche de protection, ce procédé comprenant des étapes de fabrications connues en soi, et permettant un traitement par lot.

Un autre objet de la présente invention est de prévoir un tel procédé répondant aux critères traditionnels en industrie liés au coût, au rendement et à l'environnement, eu égard aux procédés de fabrication classiques.

Ces objets, ainsi que d'autres, sont atteints par la structure selon la revendication 1, et par le procédé selon la revendication 8 ou 11.

Un avantage de la seconde couche de la structure selon la présente invention est de recouvrir les différentes zones susceptibles d'être attaquées par l'agent réactif tel que KOH, notamment les plots de connexion en aluminium, ce qui confère à la structure une protection contre cet agent. Il en résulte que cette structure a un rendement supérieur à 99,8 %.

Un autre avantage de la seconde couche de la structure selon la présente invention est de conférer une résistance à l'agent réactif, de sorte que cette structure peut subir un traitement par lot, c'est-à-dire sans avoir recours à un équipement mécanique spécifique, contrairement aux structures classiques.

Un autre avantage de la seconde couche de la structure selon la présente invention est de recouvrir également les faces latérales des lignes séparant deux puces successives du substrat, ce qui confère à la structure une protection supplémentaire contre cet agent.

Un autre avantage de la seconde couche de la structure selon la présente invention est de recouvrir également les trous de la première couche (c'est-à-dire la couche de passivation), de sorte que la solution de gravure ne peut pas être canalisée par ces trous jusqu'aux couches inférieures susceptibles d'être attaquées par l'agent réactif, ce qui confère à la structure une protection supplémentaire contre cet agent.

Un avantage du procédé selon la présente invention est de comprendre des étapes de fabrication, chacune d'elles étant connue en soi.

Un autre avantage du procédé selon la présente invention est de pouvoir former la seconde couche de la structure par des étapes de photolithographie classiques.

Ces objets, caractéristiques et avantages, ainsi que d'autres, de la présente invention apparaîtront plus clairement à la lecture de la description détaillée de trois mises en oeuvre préférées de l'invention, donné à titre d'exemple uniquement, en relation avec les figures jointes, parmi lesquelles :

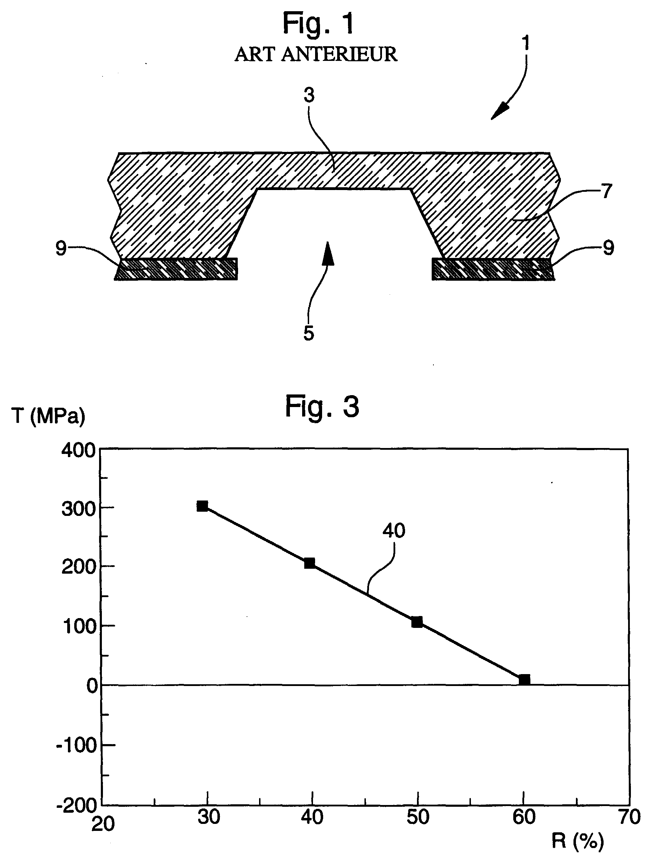

- la figure 1 déjà citée représente une vue en coupe schématique d'un capteur de pression classique;
- la figure 2 représente un mode de réalisation préféré d'une structure selon la présente invention;
- la figure 3 représente des données expérimentales relatives aux contraintes résiduelles en fonction de différentes valeurs de pourcentage de puissance, ainsi que des régressions linéaires de ces données;
- la figure 4 représente une première variante de réalisation de la structure de la figure 2;
- la figure 5 représente une seconde variante de réalisation de la structure de la figure 2; et
- les figures 6A à 6G représentent des vues en coupe schématiques de la structure de la figure 2, en cours de fabrication.

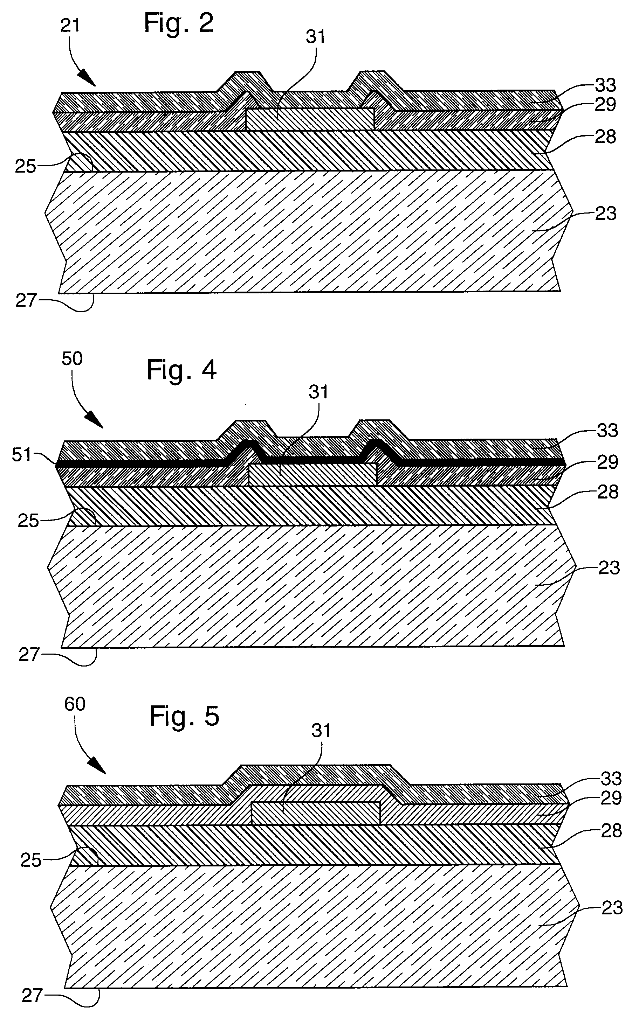

La figure 2 représente un mode de réalisation préféré d'une structure 21 selon la présente invention.

La structure 21 est formée sur un substrat 23 ayant une première face 25 ou face avant, et une seconde face 27 ou face arrière, et constitué d'un matériau de base destiné à être gravé par un agent réactif A. De préférence, ce matériau de base est le silicium, et l'agent A est KOH. En outre, dans le cas typique de la réalisation d'un capteur de pression du type susmentionné, on forme sur la face 25 une couche 28 en oxyde de silicium.

On notera, dans la suite de la description, que les notions de face avant et de face arrière peuvent être définies pour chacune des couches qui seront formées sur le substrat 23, de sorte que toutes les faces avant sont situées du même côté que la face 25, et que toutes les faces arrière sont situées du même côté que la face 27.

La structure 21 comprend une première couche externe 29 qui joue le rôle de couche de passivation. La couche 29 est formée de manière à ne pas couvrir au moins une zone 31 constituée d'un matériau susceptible d'être attaqué par l'agent A.

La structure 21 comprend en outre une seconde couche externe 33 formée sur la face avant de la couche 29, de manière à recouvrir cette face et, en particulier, la zone découverte 31. Autrement dit, la structure 21 comprend une double couche de passivation.

Un avantage de former la couche 33 de la structure 21 réside dans le fait que cette structure est particulièrement résistante à l'agent réactif tel que KOH.

En effet, on rappelle que cet agent peut occasionner une détérioration des plots de connexion en aluminium d'une telle structure, comme cela a déjà été mentionné ci-dessus. Ainsi, la résistance à l'agent KOH d'une structure de ce type peut donc être estimée à partir du nombre de plots de connexion détériorés. Dans la suite de la présente description, un rendement est défini comme le pourcentage de plots de connexion non détériorés au terme de la gravure par KOH, par rapport au nombre total de plots formés sur un substrat donné. Typiquement, le rendement d'une structure selon la présente invention est supérieur à 99,8 %, cette estimation ayant été effectuée sur un échantillon d'environ 24500 plots.

En outre, puisque la couche 33 recouvre la face avant de la structure 21, cette couche recouvre également les lignes séparant deux puces successives du substrat, ce qui confère aux faces latérales de ces lignes une protection contre une attaque par l'agent KOH.

Enfin, puisque la couche 33 recouvre la face avant de la structure 21, elle recouvre également les trous de la couche de passivation, c'est-à-dire de la couche 29, dans lesquels la solution de gravure peut être canalisée, ce qui confère aux couches inférieures une protection contre une attaque par l'agent KOH.

Autrement dit, la couche 33 protège la structure 21 contre une attaque de l'agent KOH.

De préférence, les couches 29 et 33 sont constituées d'au moins un matériau tel que le nitrure de silicium et l'oxyde de nitrure de silicium.

Par ailleurs, les couches 29 et 33 sont également formées de manière à avoir respectivement un premier comportement élastique, et un second comportement élastique qui est différent du premier, comme cela est décrit de façon plus détaillée ci-dessous.

En effet, dans le cas typique de la réalisation d'un capteur de pression du type susmentionné, la face 27 de la structure 21 représentée en figure 2 est destinée à subir une gravure par KOH, de manière à former une membrane fine ayant une épaisseur sensiblement égale à la somme de celles des couches 28 et 29. Dans ce cas, il est avantageux que la couche 29 ait un comportement élastique lui conférant une élasticité en traction, de manière à aplanir la membrane. Il est également avantageux que la couche 33 ait un comportement élastique lut conférant une élasticité en compression qui est supérieure à celle de la première couche, comme cela est décrit de façon plus détaillée ci-après.

A titre de variante, une partie de la face 25 du substrat 23 peut être destinée à subir une gravure par l'agent réactif tel que KOH, en ayant préalablement prévu des ouvertures (non représentées) à travers les couches inférieures telles que les couches 29 et 33, de sorte que ladite partie à graver est découverte. Dans ce cas, il est avantageux que la couche 33 ait un comportement élastique lui conférant une élasticité en traction supérieure à celle de la couche 29.

On rappelle que les couches 29 et 33 peuvent être formées par une technique de dépôt par plasma, qui est connue en soi. Un tel plasma est créé dans un réacteur par l'utilisation simultanée d'un générateur basse-fréquence et d'un générateur haute-fréquence. La référence LF désigne la fréquence de fonctionnement du générateur basse-fréquence, et la référence HF désigne la fréquence de fonctionnement du générateur haute-fréquence.

En particulier, la contrainte de la couche à former est déterminée par la densité et l'énergie du bombardement ionique commandé par les deux générateurs. En effet, il est possible de déterminer cette contrainte en variant le rapport de puissance entre les fréquences LF et HF. Typiquement, une augmentation de la puissance fournie à la fréquence LF, confère à la couche formée une plus grande élasticité en compression.

A titre d'exemple uniquement, la figure 3 illustre un tel comportement, dans le cas de couches en nitrure de silicium déposées par un procédé du type susmentionné.

La figure 3 représente des données expérimentales des contraintes résiduelles T de ces couches, en fonction de différentes valeurs du rapport R entre la puissance fournie à la fréquence LF et la puissance totale fournie, ainsi qu'une régression linéaire désignée 40 de ces données. On note en figure 3 que, lorsqu'on augmente la puissance fournie à la fréquence LF, la contrainte T diminue, ce qui confère à la couche une plus grande élasticité en compression. On notera également que la figure 3 est extraite de la thèse de D. Jaeggi déjà citée.

Il va de soi que d'autres paramètres de dépôt tels que la pression du réacteur, la température du substrat, et les pressions partielles des différents gaz présents dans le réacteur, ont également une influence sur les propriétés d'élasticité de cette couche. Toutefois ces paramètres sont prédéterminés dans le cadre d'une couche de passivation classique, par exemple, pour optimiser l'uniformité de cette couche, et pour diminuer le nombre de trous indésirables traversant cette couche.

Par ailleurs, la Demanderesse de la présente invention a observé que le rendement tel que défini ci-dessus, croît quand on augmente la puissance fournie à la fréquence LF.

A titre de perfectionnement, les figures 4 et 5 représentent respectivement des première et seconde variantes de réalisation de la structure de la figure 2.

On note que les structures 50 et 60 représentées en figures 4 et 5 respectivement, sont proches de la structure 21 représentée en figure 2. Ainsi, par souci de simplicité, les couches représentées en figures 4 et 5, et désignées par les mêmes références que celles représentées en figure 2, sont sensiblement identiques à celles désignées en figure 2.

Comme le représente la figure 4, la structure 50 comprend en outre une couche d'adhérence 51 formée entre les couches 29 et 33, de manière à augmenter l'adhérence entre les couches 29 et 33, et à servir de modérateur d'élasticité. On note que la couche 51 est communément appelée en anglais "adhesion promoter". De préférence, la couche 51 est constituée à partir d'une solution communément appelée TEOS (acronyme de l'anglais "Tetraetoxysilane").

Comme le représente la figure 5, la structure 60 est formée de sorte que la couche 29 recouvre au moins une zone 31 constituée d'un matériau susceptible d'être attaqué par l'agent A. Il en résulte que la face avant de la couche 33 est plane au-dessus de cette zone. Autrement dit, une telle structure diminue avantageusement la hauteur de marche qui doit être recouverte par la couche 33.

La structure selon la présente invention telle que décrite en relation avec la figure 2, 4 ou 5, peut être réalisée par un procédé de fabrication comprenant plusieurs étapes de fabrication, chacune d'elles étant connue en soi.

A titre illustratif uniquement, on va décrire un tel procédé destiné à fabriquer la structure 21 de la figure 2.

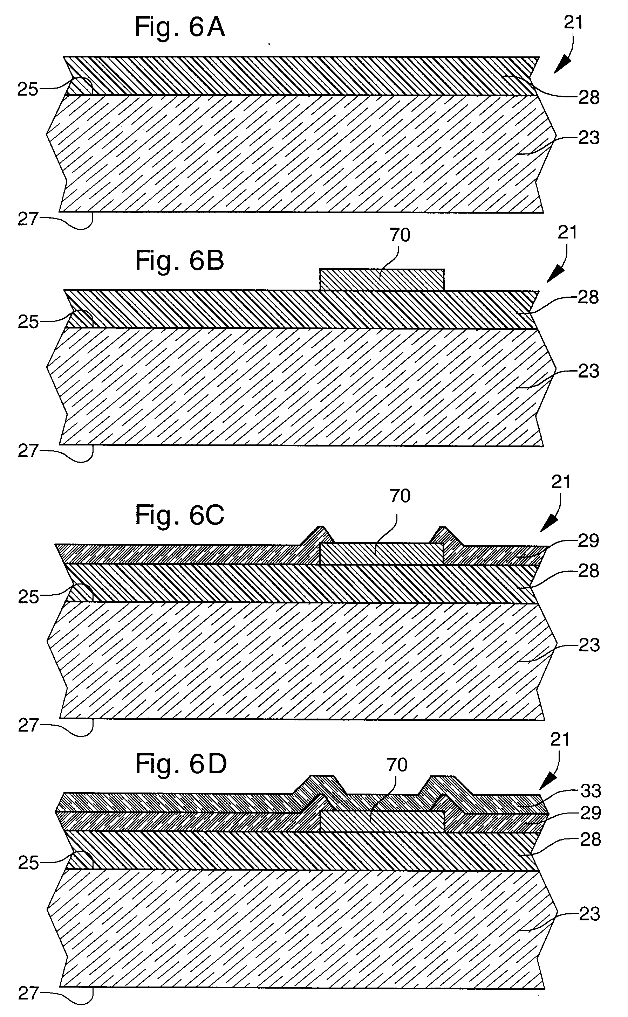

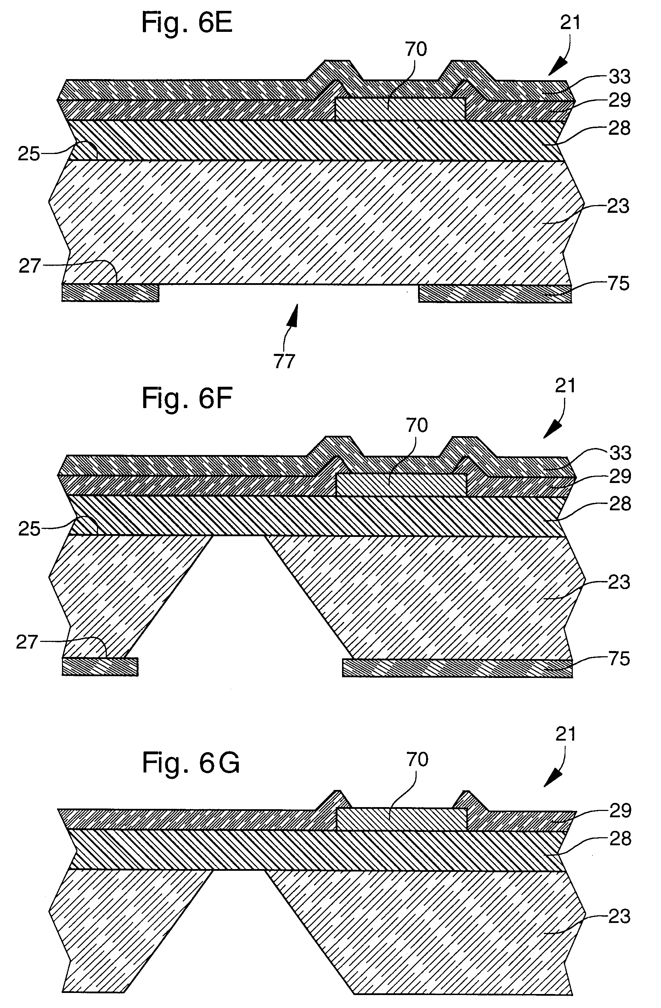

Ce procédé peut être constitué par une séquence de sept étapes successives désignées "a" à "g" respectivement. Les figures 6A à 6G représentent des vues en coupe schématiques de la structure 21 en cours de fabrication, au terme des étapes "a" à "g" respectivement.

Au cours de l'étape "a", on forme un substrat 23 en silicium ayant une face 25 ou face avant, et une face 27 ou face arrière. Ensuite on dépose, sur la face 25, une couche 28 en oxyde de silicium. La figure 6A représente la structure 21 au terme de l'étape "a".

Puis, l'étape "a" est suivie de l'étape "b". Au cours de l'étape "b", on forme un plot de connexion 70 sur la face avant de la couche 28. A cet effet, on dépose d'abord une couche en aluminium sur la face avant de la couche 28. Puis, on fait subir à la couche d'aluminium des étapes classiques de photolithographie qui consistent à déposer une couche de résine photosensible sur la face avant de la couche d'aluminium, insoler et développer la couche de résine, graver les zones découvertes de la couche d'aluminium, et supprimer les zones restantes de résine. La figure 6B représente la structure 21 au terme de l'étape "b".

Puis, l'étape "b" est suivie de l'étape "c". On forme, sur la face avant de la couche 28, une couche 29 en nitrure de silicium par un procédé de dépôt par plasma, de sorte que la couche 29 a un premier comportement élastique, comme cela est décrit de façon plus détaillée ci-dessus. Ensuite, on réalise une zone d'ouverture 31 à travers la couche 29, par des étapes de photolithographie telles que décrites ci-dessus. La figure 6C représente la structure 21 au terme de l'étape "c".

Puis, l'étape "c" est suivie de l'étape "d". Au cours de l'étape "d", on forme, sur la face avant de la couche 29, une couche 33 en nitrure de silicium par un procédé de dépôt semblable à celui mis en oeuvre au cours de l'étape "c". La couche 33 est formée de manière à avoir un comportement élastique lui conférant une élasticité en compression supérieure à celle de la couche 29. La figure 6D représente la structure 21 au terme de l'étape "d".

Puis, l'étape "d" est suivie de l'étape "e". Au cours de l'étape "e", on forme, sur la face 27, une couche de masquage 75 en nitrure de silicium, à laquelle on fait subir des étapes de photolithographie telles que décrites ci-dessus. Au terme de ces étapes, on a réalisé une ouverture 77 de la couche 75. La figure 6E représente la structure 21 au terme de l'étape "e".

Puis, l'étape "e" est suivie de l'étape "f". Au cours de l'étape "f", on réalise une gravure humide par KOH de la partie non couverte de la face 27 du substrat 23, de manière à former une cavité désirée dans la structure 21 pour réaliser, par exemple, un capteur de pression. La figure 6E représente la structure 21 au terme de l'étape "e".

L'homme de l'art note qu'une telle gravure ne nécessite plus l'utilisation d'un équipement mécanique spécifique tel que décrit dans la thèse de D. Jaeggi. En effet, il n'est plus nécessaire de protéger mécaniquement la face avant du substrat, contre une attaque potentielle des ions K⁺ présents dans la solution de gravure, puisque les zones susceptibles d'être attaquées par l'agent KOH sont recouvertes par la couche 33. Autrement dit, la structure selon la présente invention peut être gravée par l'agent KOH, au cours d'un traitement par lot, contrairement à des structures classiques. Ceci est particulièrement avantageux, eu égard aux préoccupations habituelles de coût et de rendement dans l'industrie des semiconducteurs.

Puis, l'étape "f" est suivie de l'étape "g". Au cours de l'étape "g", on grave la couche 33, ainsi que les zones restantes de la couche 75, pour les supprimer, en utilisant, par exemple, un procédé de gravure de type R.I.E. (acronyme de l'anglais "Reactive Ion Etching"). La figure 6G représente la structure 21 au terme de l'étape "g".

A titre de variante, on peut prévoir de ne pas supprimer la couche 33, notamment dans le cas où la structure selon la présente invention ne comporte pas de plots de connexion. Il en résulte que les comportements élastiques des couches 29 et 33 peuvent être inversés par rapport à ceux de la structure 21 telle que décrite ci-dessus.

A titre de perfectionnement, on peut modifier la séquence de réalisation décrite ci-dessus en relation avec les figures 6A à 6G, de manière à pouvoir réaliser les variantes de réalisation de la structure de la figure 2, c'est-à-dire les structures 50 et 60 des figures 4 et 5.

Considérons le cas de la structure 50 de la figure 4. Dans ce cas, on insère une étape de fabrication supplémentaire entre l'étape "c" et l'étape "d". Au cours de cette étape supplémentaire, on forme, sur la face avant de la couche 29, une couche d'adhérence 51 par un procédé de dépôt semblable à celui mis en oeuvre à l'étape "d". A cet effet, on peut utiliser une solution communément appelée TEOS (déjà citée dans la présente description). Par la suite, on réalise les étapes "d" à "g" telles que décrites ci-dessus. En outre, l'étape "g" est suivie d'une étape "h", au cours de laquelle on supprime la couche 51 par un procédé de gravure connu en soi.

Considérons maintenant le cas de la structure 60 de la figure 5. Dans ce cas, on ne réalise pas les étapes de photolithographie de l'étape "c", de manière à ne pas former la zone d'ouverture 31 décrite ci-dessus en relation avec la figure 2. Ensuite, on réalise l'étape "d" telle que décrite ci-dessus. Puis on insère une étape de fabrication supplémentaire entre l'étape "d" et l'étape "e". Au cours de cette étape supplémentaire, on forme une zone d'ouverture dans la couche 33, au-dessus du plot de connexion 70. Par la suite, on réalise les étapes "e" à "g" telles que décrites ci-dessus. En particulier, au cours de l'étape "g", une zone d'ouverture se forme à travers la couche 29, et au-dessus du plot de connexion 70.

A titre de variante, dans le cas où l'on souhaite graver une partie de la face avant d'un substrat d'une structure selon la présente invention, on peut prévoir un procédé de fabrication comprenant les première et seconde étapes qui suivent. La première étape consiste à former la première couche 29, puis la seconde couche 33, de sorte que les première et seconde couches ne recouvrent pas une partie de la face avant du substrat. Et la seconde étape consiste à graver par l'agent A la partie non recouverte de la face avant du substrat, de manière à former une cavité désirée, par exemple.

Il va de soi pour l'homme de l'art que la description détaillée ci-dessus peut subir diverses modifications sans sortir du cadre de la présente invention. A titre d'exemple, on peut prévoir d'utiliser d'autres agents de gravure, ainsi que matériaux que le nitrure de silicium adaptés à ces agents. A titre d'exemple également, on peut prévoir de former une structure selon la présente invention comprenant, en sus des première et seconde couches externes, des couches de passivation supplémentaires formées de sorte que l'une de ces couches a une élasticité en compression qui est supérieure à celles des autres couches. Dans ce cas, il va de soi que ces couches peuvent ne pas être formées en un matériau unique tel que le nitrure de silicium et l'oxyde de nitrure de silicium.

## Revendications

1. Structure (21) formée sur un substrat (23) ayant une première face (25), ou face avant, et une seconde face (27), ou face arrière, et constitué d'un matériau de base destiné à être gravé par un agent réactif (A), cette structure comprenant au moins une première couche externe (29), ou couche de passivation, qui a un premier comportement élastique, cette structure étant caractérisée en ce qu'elle comprend en outre au moins une seconde couche externe (33) formée au-dessus de la première couche, de sorte que la seconde couche a un second comportement élastique qui est différent du premier comportement élastique.

2. Structure (21) selon la revendication 1, caractérisée en ce que le second comportement élastique confère, à la seconde couche, une élasticité en compression qui est supérieure à celle de la première couche.

3. Structure (21) selon l'une quelconque des revendications précédentes, la première couche étant formée de manière à ne pas couvrir au moins une zone (31) constituée d'un matériau susceptible d'être attaqué par l'agent réactif, cette structure étant caractérisée en ce que la seconde couche (33) recouvre ladite zone (31).

4. Structure (21) selon l'une des revendications précédentes, caractérisée en ce qu'elle comprend en outre une couche d'adhérence (51) formée entre la première couche et la seconde couche.

5. Structure (21) selon la revendication 4, caractérisée en ce que la couche d'adhérence est formée en nitrure de silicium, à partir d'une solution communément appelée TEOS.

6. Structure (21) selon la revendication 1 ou 2, la première couche étant formée de manière à recouvrir au moins une zone (31) constituée d'un matériau susceptible d'être attaqué par l'agent réactif, cette structure étant caractérisée en ce que la face avant de la seconde couche est plane au-dessus de ladite zone (31).

7. Structure (21) selon l'un des revendications précédentes, caractérisée en ce que les première et seconde couches sont constituées d'au moins un matériau tel que le nitrure de silicium et l'oxyde de nitrure de silicium.

8. Procédé pour fabriquer la structure selon l'une des revendications précédentes, ce procédé pouvant comprendre des étapes consistant à former au moins une couche intermédiaire sur la face avant du substrat, ce procédé étant caractérisé en ce qu'il comprend une séquence d'étapes successives comprenant :
- une première étape ("c") consistant à former, sur la face avant du substrat, la première couche (29);
- une deuxième étape ("d") consistant à former, sur la face avant de la première couche, la seconde couche (33);
- une troisième étape ("e") consistant à former, sur la face arrière du substrat, une couche de masquage (75) pourvue d'une ouverture (77); et
- une quatrième étape ("f") consistant à graver la partie non couverte de la face arrière du substrat par l'agent réactif (A).

9. Procédé selon la revendication 8, et la structure à fabriquer selon la revendication 4 ou 5, ce procédé étant caractérisé en ce qu'il comprend en outre une cinquième étape qui suit la première étape et précède la deuxième étape, la cinquième étape consistant à former, sur la face avant de la première couche, la couche d'adhérence (51).

10. Procédé selon la revendication 8, et la structure à fabriquer selon la revendication 6, ce procédé étant caractérisé en ce que la première étape est remplacée par une sixième étape consistant à former, sur la face avant du substrat, la première couche (29) de sorte que cette couche recouvre la face avant du substrat; et en ce qu'il comprend en outre une septième étape qui suit la deuxième étape et précède la troisième étape, la septième étape consistant à former une zone d'ouverture dans la seconde couche, au-dessus de ladite zone (31).

11. Procédé pour fabriquer la structure selon l'une des revendications 1 à 7, ce procédé étant caractérisé en ce qu'il comprend une séquence d'étapes successives comprenant :
- une première étape consistant à former la première couche (29), puis la seconde couche (33) de sorte que les première et seconde couches ne recouvrent pas une partie de la face avant du substrat; et
- une seconde étape consistant à graver, par l'agent réactif (A), la partie non recouverte de la face avant du substrat.
